# EUROPÄISCHE PATENTANMELDUNG

(11) **EP 2 589 987 A1**
(43) Veröffentlichungstag der Anmeldung: **08.05.2013**
(21) Anmeldenummer: 11188062.1
(22) Anmeldetag: 07.11.2011
(51) Int. Cl.: G01V 3/08, G01V 3/10

(54) **Ortungsgerät**

(71) Anmelder: Robert Bosch GmbH, 70442 Stuttgart (DE)
(72) Erfinder: Krapf, Reiner, 70794 Filderstadt (DE); Zibold, Tobias, 70567 Stuttgart (DE); Albrecht, Andrej, 70567 Stuttgart (DE)

(57) **Zusammenfassung**

Ein Ortungsgerät zur Erfassung eines Gegenstandes umfasst eine GegentaktMessbrücke zum Ansteuern einer ersten und einer zweiten elektromagnetischen Einrichtung jeweils in einem variablen Verhältnis, wobei die erste elektromagnetische Einrichtung in Abhängigkeit der Ansteuerung ein elektromagnetisches Wechselfeld im Bereich des Gegenstandes erzeugt. Das Ortungsgerät umfasst ferner einen Vergleicher zur Erfassung des Gegenstandes, falls sich das variable Verhältnis von einem vorbestimmten Verhältnis um mehr als ein vorbestimmtes Maß unterscheidet.

## Beschreibung

Die Erfindung betrifft ein Ortungsgerät. Insbesondere betrifft die Erfindung ein Ortungsgerät mit den Merkmalen von Anspruch 1 zur Detektion eines in einem Medium eingeschlossenen Objektes

### Stand der Technik

Zur Erfassung eines in einer Wand verborgenen Gegenstandes sind unterschiedliche Ortungsgeräte bekannt. Der in der Wand verborgene Gegenstand kann beispielsweise eine Wasser-, Strom- oder Gasleitung sein, die bei einer Bearbeitung der Wand nicht beschädigt werden soll. Der Gegenstand kann andererseits auch ein Holzbalken oder eine andere tragende Struktur sein, und die Bearbeitung soll im Bereich der tragenden Struktur stattfinden.

Um einen metallischen Gegenstand, wie etwa ein stählernes Wasserrohr, innerhalb der Wand aufzuspüren, wird üblicherweise ein magnetisches Feld erzeugt und überprüft, ob der Gegenstand das magnetische Feld beeinflusst. Übersteigt die Beeinflussung ein vorbestimmtes Maß, so wird der Gegenstand erfasst. Ein nichtmetallischer Gegenstand, wie etwa ein Holzbalken, kann anhand seiner dielektrischen Eigenschaften detektiert werden. Dazu wird ein elektrisches Feld erzeugt und überprüft, inwieweit der Gegenstand das elektrische Feld beeinflusst. Der Gegenstand wird erfasst, wenn die Beeinflussung ein vorbestimmtes Maß übersteigt. Ist der Gegenstand ein strom- oder spannungsführender Leiter, so kann auch ein elektromagnetisches Feld detektiert werden, welches den Leiter umgibt. Gegenstände, die weder metallisch sind noch leicht detektierbare Dielektrizitätseigenschaften haben, wie etwa eine kunststoffummantelte, kupferne Stromleitung, können auf diese Weise erfasst werden.

Ein grundsätzliches Problem bei Ortungsgeräten besteht darin, dass sie bei Erhöhung einer Erfassungsempfindlichkeit zu Fehlmessungen neigen. Die Ortungsgeräte müssen daher im Bereich des Messortes von einem Benutzer kalibriert werden. Die Kalibrierung kann den Messvorgang aufwändig und mehrdeutig machen.

Der Erfindung liegt die Aufgabe zugrunde, ein empfindliches Ortungsgerät mit einfacher Bedienbarkeit bereitzustellen.

### Offenbarung der Erfindung

Die Erfindung löst das Problem mit einem Ortungsgerät mit den Merkmalen des Anspruchs 1. Unteransprüche geben bevorzugte Ausführungsformen wieder.

Ein erfindungsgemäßes Ortungsgerät zur Erfassung eines Gegenstandes, insbesondere eines in einem Medium eingeschlossenen Objektes, umfasst eine Gegentakt-Messbrücke zum Ansteuern einer ersten und oder einer zweiten elektromagnetischen Einrichtung. Eine derartige Gegentaktbrücke ist beispielsweise in der DE 10 2010 028 723 A1 oder der DE 10 2010 031 147 A1 für eine induktive elektromagnetische Einrichtung bekannt. Die DE 10 2010 028 718 A1 zeigt eine derartige Gegentaktbrücke für eine kapazitive elektromagnetische Einrichtung. Eine solche Gegentakt-Messbrücke weist einen Oszillator zur Versorgung der kapazitiven Elektroden (im Fall der kapazitive elektromagnetische Einrichtung) bzw. der Spulen (im Fall der induktiven elektromagnetische Einrichtung) mit phasenverschobenen Wechselspannungen auf. Ferner besitzt eine solche Gegentakt-Messbrücke eine Steuereinrichtung zur Steuerung von Amplituden wenigstens einer dieser Wechselspannungen.

Im Fall der induktiven elektromagnetische Einrichtung werden die Sendespulen mit alternierenden Spannungen beaufschlagt, so dass ein zu den alternierenden Spannungen taktsynchroner Wechselspannungsanteil, der beispielsweise mittels einer Empfangsspule detektiert, d.h. in dieser induziert wird, betragsmäßig minimiert ist.

Alternativer Weise kann bei der induktiven elektromagnetische Einrichtung auch auf eine Empfangsspule verzichtet werden und ein zu den alternierenden Spannungen taktsynchroner Wechselspannungsanteil, der Differenzspannung gemessen und betragsmäßig minimiert werden. Dazu kann beispielsweise eine Einrichtung aus zwei in Serie geschalteten ohmschen Widerständen, die jeweils Teil des komplexen Widerstandes der Sendespulen sein können.

Im Fall der kapazitiven elektromagnetische Einrichtung werden die Kapazitätseinrichtung, d.h. die kapazitiven Elektroden mit alternierenden Spannungen beaufschlagt. Die Steuereinrichtung ist dazu eingerichtet, die alternierenden Spannungen derart zu verstärken, dass ein zu den alternierenden Spannungen taktsynchroner Wechselspannungsanteil minimiert wird. Der Wechselspannungsanteil kann beispielsweise mittels einer Potentialsonde, entsprechend der in Figur 1 der DE 10 2010 028718 A1 gezeigten Anordnung gemessen werden

Die erste elektromagnetische Einrichtung erzeugt in Abhängigkeit der Ansteuerung ein elektromagnetisches Wechselfeld im Bereich des Gegenstandes. Ein Vergleicher des Ortungsgeräts erfasst den Gegenstand, falls sich das variable Verhältnis von einem vorbestimmten Verhältnis um mehr als ein vorbestimmtes Maß unterscheidet.

Die Gegentakt-Messbrücke ist, wie bereits ausgeführt, aus anderen Anwendungen im Stand der Technik grundsätzlich bekannt, so auch beispielsweise aus der DE 10 2008 005 783 A1, die allerdings kein Ortungsgerät zur Detektion von in einem Medium eingeschlossenen Objekten offenbart.

Mittels einer solchen Gegentakt-Messbrücke kann feldkompensiert gemessen werden, so dass ein großer Messbereich mit einer hohen Empfindlichkeit des Ortungsgeräts vereinbar sein kann. Ferner kann mittels der Gegentakt-Messbrücke differenziell gemessen werden, so dass eine Kalibrierung durch einen Benutzer des Ortungsgeräts entfallen kann. Die Gegentakt-Messbrücke kann verwendet werden, um alternativ mittels eines magnetischen oder eines elektrischen Feldes zu messen. Die jeweils andere Komponente des elektromagnetischen Feldes geht dabei gegen Null.

In einer Ausführungsform des Erfindungsgemäßen Ortungsgerätes ist eine Gegentakt-Messbrücke dazu vorgesehen, mittels eines Umschalters eine erste elektrische Einrichtung, und / oder eine erste elektrische Einrichtung, wahlweise anzusteuern. Die erste elektrische Einrichtung umfasst dabei zumindest zwei Spulen, insbesondere Sendespulen und dient als induktiver Sensor, der es beispielsweise ermöglicht, metallische Objekte zu detektieren.

Die zweite elektrische Einrichtung umfasst dabei zumindest zwei kapazitive Elektroden, und dient als kapazitiver Sensor, der es beispielsweise ermöglicht, dielektrische Objekte zu detektieren.

In vorteilhafter Weise ist die als Gegentakt-Messbrücke ausgebildete Ansteuervorrichtung in Form eines IC (Integrated Circuit), insbesondere in Form eines ASIC, ausgebildet und im Gehäuse der Vorrichtung angeordnet.

Das erfindungsgemäße Ortungsgerät besitzt eine Ausgabeeinrichtung, insbesondere in Form eines Flächendisplays, wie beispielsweise eines LCD Displays welches es ermöglicht, ein auf das Objekt hinweisendes Signal, insbesondere ein optisches Signal auszugeben. Das erfindungsgemäße Ortungsgerät ermöglicht es , dass das auf ein Objekt hinweisende Signal insbesondere auch darauf hinweist, welcher Art von Gegenstand (metallisch, magnetisch, Holz, stromführende Leitung und dergleichen) erfasst wurde.

Das Ortungsgerät kann eine Einrichtung zur Veränderung des vorbestimmten Maßes durch einen Benutzer umfassen. Dadurch kann der Benutzer die Empfindlichkeit des Ortungsgeräts einstellen. Die Einstellung des vorbestimmten Maßes kann im Einklang mit einer Verstärkung von Steuersignalen durchgeführt werden, die der ersten und der zweiten elektromagnetischen Einrichtung zugeführt werden, so dass die erzeugten elektromagnetischen Felder entsprechend verstärkt sind. In einer Ausführungsform kann das vorbestimmte Maß zwischen mehreren vorbestimmten Werten umgeschaltet werden, etwa zwei oder drei Werten, so dass das Ortungsgerät über unterschiedliche Empfindlichkeiten verfügt, die einfach durch den Benutzer angewählt werden können.

Das erfindungsgemäße Ortungsgerät weist zudem in einer Ausführungsform einen Weggeber zur Erfassung einer Verschiebung des Ortungsgeräts gegenüber dem Gegenstand auf. Das Ortungsgerät ist insbesondere dazu ausgebildet ist, ein Messergebnis der Gegentakt-Messbrücke einer Verschiebungsposition des Gerätes zuzuordnen. Auf diese Weise ist es möglich, einem detektierten Objekt auch Ortskoordinaten zuzuordnen.

In einer Ausführungsform des erfindungsgemäßen Ortungsgerätes ist eine weitere Gegentakt-Messbrücke mit einer weiteren elektromagnetischen Einrichtung vorhanden. Diese weitere elektromagnetische Einrichtung kann eine induktive, eine Kapazitive oder aber auch eine andere Sensoreinheit sein.

Diese weitere Gegentakt-Messbrücke kann in den gleichen IC/ASIC wie die erste Gegentaktbrücke oder aber auch in einem zweiten IC/ASIC integriert und im Ortungsgerät eingebaut sein.

Bei dem erfindungsgemäßen Ortungsgerät ist zumindest eine der elektromagnetische Einrichtungen, die mittels einer Gegentakt-Messbrücke angesteuert wird an einer Seite des Gehäuses des Gerätes, insbesondere an der der Ausgabeeinrichtung abgewandten Seite des Gehäuses, innerhalb des Gehäuses angeordnet sind.

Das erfindungsgemäße Ortungsgerät weist zur Energieversorgung zumindest eine Batterie, insbesondere zumindest eine Batterie in Form eines wiederaufladbaren Akkus auf.

In einer alternativen Ausführungsform des erfindungsgemäßen Ortungsgerätes kann eine erste elektromagnetische Einrichtung nacheinander ein magnetisches Feld und ein elektrisches Feld im Bereich des Gegenstandes erzeugen. Dazu kann die elektromagnetische Einrichtung eine Spule und eine Elektrode umfassen, die nacheinander mit der Gegentakt-Messbrücke verbunden werden.

In einer Ausführungsform werden einander entsprechende elektromagnetische Einrichtungen verwendet. Dabei kann die Gegentakt-Messbrücke derart aufgebaut sein, dass sich an einer dritten elektromagnetischen Einrichtung ein Feld einstellt, das bezüglich der anderen beiden elektromagnetischen Einrichtungen das variable Verhältnis aufweist. Alternativ dazu können elektrische Kenngrößen der ersten und der zweiten elektromagnetischen Einrichtung miteinander verglichen werden, um das variable Verhältnis zu bestimmen. In einer weiteren Ausführungsform erzeugt die zweite elektromagnetische Einrichtung kein Feld, sondern bildet eine elektrische Last für die Gegentakt-Messbrücke, die mit der elektrischen Last der ersten elektromagnetischen Einrichtung das variable Verhältnis bildet.

Zusätzlich kann das Ortungsgerät eine Vorrichtung zur Bestimmung eines elektrischen Feldes des Gegenstandes umfassen, wobei die Erfassung des Gegenstandes nacheinander auf der Basis einer Gegentakt-Messbrücke und der Vorrichtung erfolgt. Vorzugsweise wird der Gegenstand dann erfasst, wenn er mittels wenigstens einer der drei beschriebenen Vorgehensweisen erfasst wird. Dabei kann eine Ausgabeeinrichtung des Ortungsgeräts bei Erfassen des Gegenstandes ein Signal ausgeben, welches darauf hinweist, auf der Basis welcher Art von Feld der Gegenstand erfasst wurde, bzw. um welche Art von Objekt es sich handelt. Ein erstes Signal kann auf eine Messung hinweisen, die mittels der Gegentakt-Messbrücke und einem magnetischen Feld durchgeführt wurde, ein zweites Signal auf eine Messung, die mittels der Gegentakt-Messbrücke und einem elektrischen Feld durchgeführt wurde, und ein drittes Signal auf eine Messung, die mittels der Vorrichtung zur Bestimmung des elektrischen Feldes des Gegenstandes durchgeführt wurde. Das Signal kann wenigstens eines von optisch und akustisch sein.

Eine Ausführungsform des erfindungsgemäßen Ortungsgerät kann eine Vielzahl nebeneinander angeordneter erster elektromagnetischer Einrichtungen aufweisen, die nacheinander an der Gegentakt-Messbrücke betrieben werden. Dadurch kann eine Erfassung des Gegenstandes in einer oder zwei Dimensionen durchgeführt werden, wodurch der Gegenstand genauer lokalisiert werden bzw. eine Begrenzung des Gegenstandes, etwa eine Kante, leichter aufgefunden werden kann.

In einer Ausführungsform werden die mittels der unterschiedlichen ersten elektromagnetischen Einrichtungen erzielten Messergebnisse visualisiert, indem auf einer optischen Ausgabeeinrichtung Anzeigebereiche definiert sind, die jeweils einer der ersten elektromagnetischen Einrichtungen zugeordnet sind. Die Anordnung der Anzeigebereiche entspricht dabei vorzugsweise der Anordnung der ersten elektromagnetischen Einrichtungen. Einem Benutzer kann so eine optische Repräsentation des Messergebnisses dargeboten werden, die intuitiv begreifbar und hochgradig detailliert ist.

Eine Entfernung des Gegenstandes vom Ortungsgerät kann zu einer Farbänderung der optischen Ausgabeeinrichtung korrespondieren. Ist die optische Ausgabeeinrichtung einfach, und damit kostengünstig gehalten, beispielsweise in Form von wenigen Leuchtdioden, so kann durch die Farbänderung mit geringem Aufwand das Messergebnis genauer dargestellt werden, wobei Mehr-Farb-LED oder hinterleuchtete LCD-Displays verwendet werden können. Ist die optische Ausgabeeinrichtung aufwändiger, beispielsweise in Form einer farbfähigen grafischen Flächenausgabe wie einer grafikfähigen Flüssigkristallanzeige, so kann durch eine Falschfarbendarstellung die Entfernung des Gegenstandes grafisch dargestellt werden. Auch in diesem Fall kann die farbige Darbietung der Messergebnisse zu einer verbesserten Bedienbarkeit durch einen Benutzer führen.

Es kann ein Abstandssensor vorgesehen sein, um ein flächiges Aufliegen des Ortungsgeräts auf einer Messfläche sicherzustellen. Die Messfläche ist üblicherweise eine im Wesentlichen ebene Fläche im Bereich des Ortungsgeräts, etwa eine Wand, insbesondere eine Leichtbauwand, eine Decke oder ein Boden. Eine der Messfläche zugewandte Seite des Ortungsgeräts ist üblicherweise auch eben und der Abstandssensor überwacht eine zumindest ungefähre Parallelität zwischen der Messfläche und dem Ortungsgerät. Liegt das Ortungsgerät nicht ausreichend eben auf der Messfläche auf, kann das vorbestimmte Verhältnis in Entsprechung der Abweichung von der Parallelität angepasst werden, um das Messergebnis konstant zu halten. Zusätzlich oder alternativ kann eine Warnung an den Benutzer des Ortungsgeräts ausgegeben werden.

Das Ortungsgerät kann auch einen Weggeber zur Erfassung einer Verschiebung des Ortungsgeräts gegenüber dem Gegenstand umfassen, wobei das Ortungsgerät dazu ausgebildet ist, ein Messergebnis der Gegentakt-Messbrücke einer Verschiebungsposition zuzuordnen. Dadurch kann es einem Benutzer ermöglicht werden, einen Messbereich mit dem Ortungsgerät zu überstreichen und dadurch eine Vielzahl Messergebnisse aufzuzeichnen, die anschließend beispielsweise grafisch dargestellt werden können. In einer Ausführungsform können ein Bildausschnitt und/oder eine Vergrößerungsstufe der grafischen Darstellung gewählt und auf der optischen Anzeigeeinrichtung des Ortungsgeräts dargestellt werden.

Das Ortungsgerät kann eine weitere Gegentakt-Messbrücke mit einer weiteren ersten und einer weiteren zweiten elektromagnetischen Einrichtung umfassen, wobei die erste elektromagnetische Einrichtung der Gegentakt-Messbrücke ein elektromagnetisches Feld mit vernachlässigbar geringem magnetischen Anteil erzeugt, während die erste elektromagnetische Einrichtung der weiteren GegentaktMessbrücke ein elektromagnetisches Feld mit vernachlässigbar geringem elektrischen Anteil erzeugt, um den Gegenstand gleichzeitig auf der Basis eines elektrischen und eines magnetischen Feldes zu erfassen.

### Kurze Beschreibung der Figuren

Im Folgenden wird die Erfindung mit Bezug auf die beigefügten Figuren genauer beschrieben, in denen:
- Fig. 1: ein Blockschaltbild einer Gegentakt-Messbrücke;
- Fig. 2: ein Ortungsgerät mit der Gegentakt-Messbrücke von Fig. 1;
- Fig. 3: unterschiedliche elektromagnetische Einrichtungen der Gegentakt-Messbrücke von Fig. 1;
- Fig. 4: eine Visualisierung einer grafischen Anzeige des Ortungsgeräts von Fig. 2; und
- Fig. 5: eine Ansicht eines beispielhaften Ortungsgeräts entsprechend Fig. 3
- Fig. 6: eine schematische Darstellung des erfindungsgemäßen Ortungsgerätes, mit beispielhafter Sensorik
zeigt.

### Genaue Beschreibung von Ausführungsbeispielen

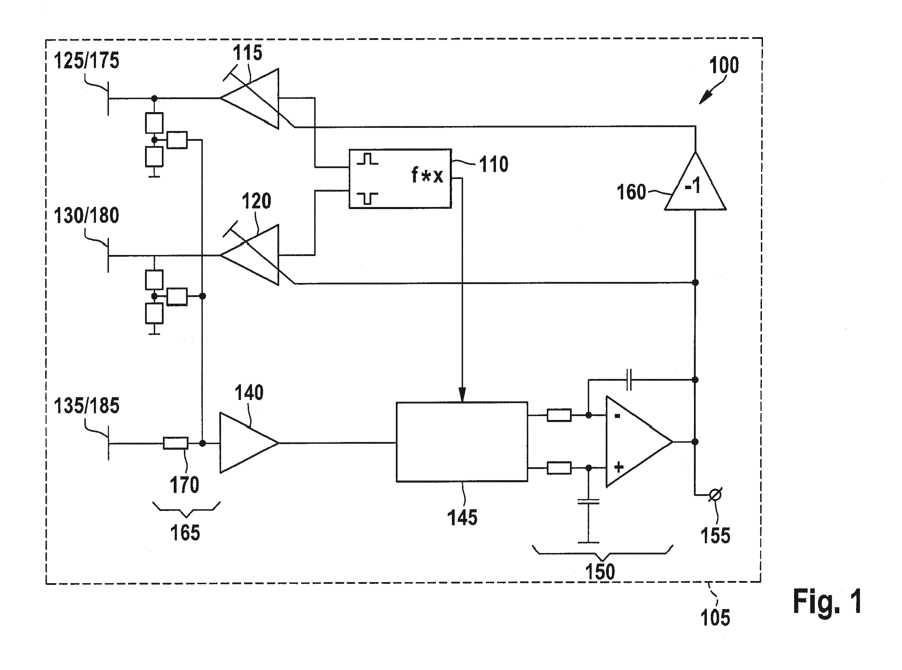

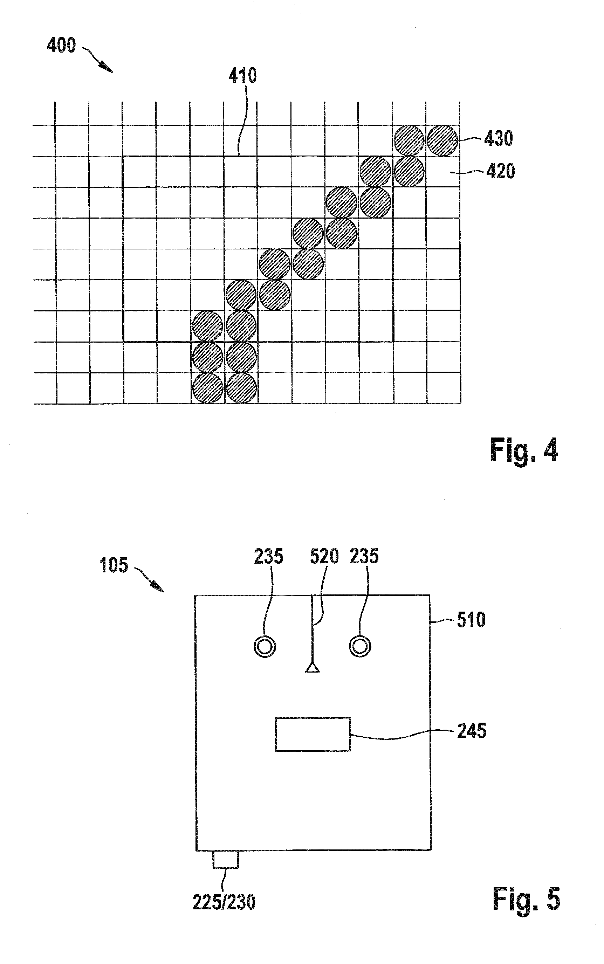

Fig. 1 zeigt ein Blockschaltbild einer Gegentakt-Messbrücke 100. Die GegentaktMessbrücke 100 ist Teil eines Ortungsgeräts 105 zum Erfassen von Gegenständen, insbesondere von in einem Medium, wie beispielsweise einer Wand, einer Decke oder einem Boden, eingeschlossenen Objekten. Das Ortungsgerät ― siehe auch Figur 5 - ist insbesondere als ein handgehaltenes Messgerät ausgebildet. Je nach Ausführung kann die Gegentakt-Messbrücke 100 zur Erfassung eines dielektrischen Gegenstandes, beispielsweise aus Holz, oder zur Erfassung eines metallischen Gegenstandes, etwa aus Stahl, verwendet werden. Im Folgenden wird zunächst die Ausführungsform beschrieben, mittels derer ein dielektrischer Gegenstand erfasst werden kann.

Ein Taktgenerator 110 hat zwei Ausgänge, an denen er phasenverschobene, vorzugsweise um 180° phasenverschobene, periodische Wechselsignale bereitstellt.

Die Wechselsignale können insbesondere Rechteck-, Dreieck- oder Sinussignale umfassen. Die Ausgänge des Taktgenerators sind mit einem ersten steuerbaren Verstärker 115 bzw. einem zweiten steuerbaren Verstärker 120 verbunden. Jeder der steuerbaren Verstärker 115, 120 verfügt über einen Steuereingang, über den er ein Signal entgegennimmt, welches einen Verstärkungsfaktor des steuerbaren Verstärkers 115, 120 steuert.

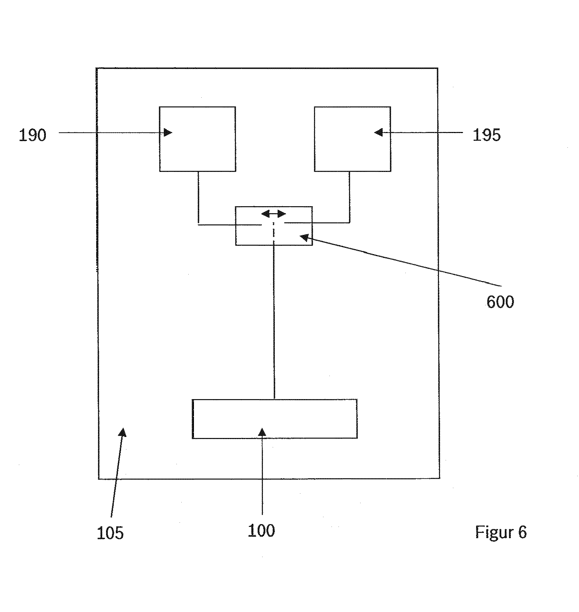

Die Signale der Gegentakt-Messbrücke werden auf eine erste elektrische Einrichtung 190 und/oder eine zweite Elektrische Einrichtung 195 mittels eines Umschalters 600 (siehe Figur 6) gegeben.

Zu Beschreibungszwecken sind die erste elektronische Einrichtung und die zweite elektronische Einrichtung in der Figur 1 als lediglich eine Einheit dargestellt, jedoch mit unterschiedlichen Bezugszeichen für die erste und zweite Einrichtung versehent.

Nachfolgend wird zuerst die zweite elektronische Einrichtung mit ihren Elektroden beschrieben.

Ein Ausgang des ersten steuerbaren Verstärkers 115 ist mit einer ersten Sendeelektrode 125 und ein Ausgang des zweiten steuerbaren Verstärkers 120 mit einer zweiten Sendeelektrode 130 der zweiten elektronischen Einheit 195 verbunden. Eine Empfangselektrode 135 dient als Potentialsonde und ist mit einem Eingangsverstärker 140 verbunden; ein im Bereich der Elektroden 125-135 dargestelltes Kompensationsnetzwerk 165 wird zunächst nicht betrachtet und eine Impedanz 170 entfällt. Diese Anordnung wird im Rahmen dieser Anmeldung als zweites elektrische Einheit bezeichnet. Die zweite elektrische Einheit wird, wie die noch zu beschreibende erste elektrische Einheit ― von der Gegentakt 100 ― Messbrücke angesteuert.

Der Eingangsverstärker 140 ist mit einem konstanten Verstärkungsfaktor dargestellt; in anderen Ausführungsformen kann jedoch ein Verstärkungsfaktor des Eingangsverstärkers 140 auch steuerbar sein. Dadurch kann beispielsweise eine räumliche Auflösung und/oder Empfindlichkeit der Gegentakt-Messbrücke 100 beeinflussbar und beispielsweise in Abhängigkeit eines Messsignals am Eingangsverstärker 140 steuerbar sein.

Der Ausgang des Eingangsverstärkers 140 ist mit einem Synchrondemodulator 145 verbunden. Der Synchrondemodulator 145 ist ferner mit dem Taktgenerator 110 verbunden und empfängt von diesem ein Taktsignal, welches auf die Phasenlage der an den Ausgängen des Taktgenerators 110 bereitgestellten Signale hinweist. In einer einfachen Ausführungsform, bei der die vom Taktgenerator 110 bereitgestellten Signale symmetrische Rechtecksignale sind, kann eines der an die steuerbaren Verstärker 115, 120 geführten Ausgangssignale als Taktsignal verwendet werden. Der Synchrondemodulator 145 schaltet im Wesentlichen auf der Basis des vom Taktgenerator 110 bereitgestellten Taktsignals das vom Eingangsverstärker 140 empfangene Messsignal alternierend an seinen oberen bzw. unteren Ausgang durch.

Die beiden Ausgänge des Synchrondemodulators 145 sind mit einem Integrator (integrierenden Komparator) 150 verbunden, der hier als mit zwei Widerständen und zwei Kondensatoren beschalteter Operationsverstärker dargestellt ist. Andere Ausführungsformen sind ebenfalls möglich, beispielsweise als aktiver Tiefpass. Auch eine digitale Ausführung im Anschluss an den Synchrondemodulator 145 ist denkbar, bei der das Signal an den Ausgängen des Synchrondemodulators 145 zu einem oder mehreren Zeitpunkten innerhalb einer Halbwelle analog zu digital gewandelt wird und dann mit dem entsprechenden Wert aus der nächsten Halbwelle verglichen wird. Die Differenz wird integriert und z.B. wieder in ein analoges Signal überführt und zur Steuerung der Verstärker 115, 120 verwendet. Während der Synchrondemodulator 145 das vom Eingangsverstärker 140 empfangene Messsignal am unteren seiner Ausgänge bereitstellt, integriert der Integrator 150 dieses Signal über die Zeit und stellt das Resultat an seinem Ausgang bereit. Während der Synchrondemodulator 145 das vom Eingangsverstärker 140 empfangene Messsignal an seinem oberen Ausgang bereitstellt, wird dieses vom Integrator 150 invertiert über die Zeit integriert und das Resultat am Ausgang des Integrators 150 bereitgestellt. Die Spannung am Ausgang des Integrators 150 ist das Integral der Differenz der tiefpassgefilterten Ausgänge des Synchrondemodulators 145.

Ist die Kapazität an der ersten Sendeelektrode 125 genau so groß wie die Kapazität an der zweiten Sendeelektrode 130, so sind die an den Ausgängen des Synchrondemodulators 145 bereitgestellten Signale im Mittel über die Zeit gleich groß und am Ausgang des Integrators 150 wird ein Signal bereitgestellt, das gegen Null (Masse) geht. Sind jedoch die Kapazitäten ungleich groß, etwa weil ein dielektrischer Gegenstand im Bereich nur einer der Sendeelektroden 125, 130 angeordnet ist, so sind die an den Ausgängen des Synchrondemodulators 145 bereitgestellten Signale im Mittel nicht mehr gleich, und am Ausgang des Integrators 150 wird ein positives oder negatives Signal bereitgestellt. Vorzeichen und Betrag des Signals weisen auf das Verhältnis der Kapazitäten hin, wobei ein Signal von Null einem Verhältnis von Eins entspricht.

Das vom Integrator 150 bereitgestellte Signal wird über einen Anschluss 155 an eine nicht dargestellte Auswerte- und Ausgabeeinrichtung des Balkenfinders 105 bereitgestellt. Die Auswerteeinrichtung kann beispielsweise einen Vergleich mit einem Schwellenwert durchführen, so dass ein Benutzer des Ortungsgeräts 105 eine optische und/oder akustische Ausgabe erhält, wenn das vom Integrator 150 bereitgestellte Signal eine vorbestimmte Schwelle überschreitet. Dabei kann das gesamte Signal oder ein Betrag des Signals mit dem Schwellenwert verglichen werden.

Das vom Integrator 150 bereitgestellte Signal wird auch zur Steuerung der Verstärkungsfaktoren der steuerbaren Verstärker 115 und 120 verwendet, wobei der zweite steuerbare Verstärker 120 unmittelbar mit dem Ausgang des Integrators 150 verbunden ist und der erste steuerbare Verstärker 115 mittels eines Inverters 160 mit dem Ausgang des Integrators 150 verbunden ist. Der Inverter 160 bewirkt eine Umkehrung des ihm bereitgestellten Signals derart, dass in Abhängigkeit des Ausgangssignals des Integrators 150 der Verstärkungsfaktor des ersten steuerbaren Verstärkers 115 in dem Maß zunimmt wie der Verstärkungsfaktor des zweiten steuerbaren Verstärkers 120 abnimmt bzw. umgekehrt. Es ist auch denkbar, dass nur der Verstärkungsfaktor eines der steuerbaren Verstärker 115, 120 gesteuert wird, während der Verstärkungsfaktor des zweiten steuerbaren Verstärkers 120, 115 auf einem festen Wert gehalten wird.

Die Verstärkungsfaktoren der steuerbaren Verstärker 115 und 120 nehmen zu bzw. ab, bis ein Wechselspannungsanteil, der zu der an den Sendeelektroden 125 und 130 anliegenden alternierenden Spannung synchron ist und an der Empfangselektrode anliegt, betragsmäßig minimiert ist.

Die Gegentakt-Messbrücke 100 ist ein Regelkreis, der dazu eingerichtet ist, ein vorbestimmtes Verhältnis an den Sendeelektroden 125 und 130 aufrecht zu erhalten. Das vorbestimmte Verhältnis ist durch den Aufbau und die Anordnung der Sendeelektroden 125 und 130 zueinander bzw. zur Empfangselektrode 135 vorgegeben. Ein variables Verhältnis ergibt sich aus den an den Sendeelektroden 125 und 130 zur Empfangselektrode 135 gebildeten Kapazitäten. Das vom Integrator 150 bereitgestellte Signal ist ein Steuersignal zur Kompensation eines asymmetrischen Einflusses auf die Kapazitäten, etwa durch den dielektrischen Gegenstand. In anderen Ausführungsformen wird das variable Verhältnis an den Elektroden auf der Basis von Strömen oder Spannungen an den Elektroden bestimmt.

Das Kompensationsnetzwerk 165 umfasst an jeder der Sendeelektroden 125, 130 einen aus zwei Impedanzen bestehenden Spannungsteiler. Die geteilten Spannungen werden mittels jeweils einer weiteren Impedanz an den Eingangsverstärker 140 geführt. Die Empfangselektrode 135 ist nicht direkt sondern mittels der Impedanz 170 an den Eingangsverstärker 140 geführt. Durch entsprechende Wahl der einzelnen genannten Impedanzen können die an den Ausgängen der steuerbaren Verstärker 115, 120 wirksamen Impedanzen verändert werden. Hierdurch kann beispielsweise eine asymmetrische Anordnung der Elektroden 125-135 kompensiert werden.

In einer weiteren Ausführungsform entfallen gegenüber der Darstellung in Fig. 1 vom Kompensationsnetzwerk 165 die Impedanzen im Bereich der ersten Sendeelektrode 125 sowie die zweite Sendeelektrode 130. Somit werden die alternierenden Spannungen der steuerbaren Verstärker 115, 120 zwischen einer an der ersten (einzigen) Sendeelektrode 125 anliegenden Kapazität und einer durch das Kompensationsnetzwerk 165 gebildeten Referenzkapazität ausbalanciert. Die Referenzkapazität ist invariant gegenüber einem dielektrischen Gegenstand. Zur Messung werden nur noch die erste Sendeelektrode 125 und die Empfangselektrode 135 benötigt.

Eine umgekehrte Ausführung, bei der gegenüber der Darstellung in Fig. 1 vom Kompensationsnetzwerk 165 die Impedanzen im Bereich der zweiten Sendeelektrode 130 sowie die erste Sendeelektrode 125 entfallen, ist ebenfalls möglich.

Durch Vorsehen von Schaltern kann die Gegentakt-Messbrücke 100 entsprechend der beschriebenen Ausführungsformen in einem Drei-Elektroden-Messbetrieb unter Verwendung beider Sendeelektroden 125 und 130, einem ersten Zwei-Elektroden-Messbetrieb unter Verwendung der ersten Sendeelektrode 125 und der Empfangselektrode 135 sowie einem zweiten Zwei-Elektroden-Messbetrieb unter Verwendung der zweiten Sendeelektrode 130 und der Empfangselektrode 135 betrieben werden. Eine Umschaltung zwischen den unterschiedlichen Messbetrieben kann zyklisch erfolgen oder durch einen Benutzer gesteuert sein.

Während im Zwei-Elektroden-Messbetrieb eine am Anschluss 155 der GegentaktMessbrücke 100 in Fig. 1 anliegende Spannung dann am größten ist, wenn der dielektrische Gegenstand der Empfangselektrode 135 am nächsten ist, ist im Drei-Elektroden-Messbetrieb der Betrag dieser Spannung dann maximal, wenn der dielektrische Gegenstand einer der Sendeelektroden 125 oder 130 am nächsten ist, wobei das Vorzeichen der Spannung auf die jeweils nächstliegende Sendeelektrode hinweist. Wird der Gegenstand an den Elektroden vorbei bewegt, ergibt sich also im Drei-Elektroden-Messbetrieb ein Signal mit einem Vorzeichenwechsel und im Zwei-Elektroden-Messbetrieb ein Signal mit einem lokalen Maximum im Moment des Passierens.

Des weiteren kann die Gegentakt-Messbrücke 100 auch zur Erfassung eines metallischen Gegenstandes verwendet werden. Dazu werden mittels eines Umschalters 600 (siehe hierzu Figur 6) die Spannungssignale der Gegentakt-Messbrücke 100 auf eine induktive elektrische Einrichtung gegeben, die im Rahmen dieser Anmeldung als erste elektrische Einheit 190 bezeichnet wird.

Die Gegentaktmessbrücke 100 steuert über den Umschalter 600 die erste und/oder die zweite elektrische Einheit an. Anstelle der Elektroden der zweiten elektrischen E werden in der ersten elektrischen Einheit im Wesentlichen Spulen verwendet. (Vergleiche nachfolgende Beschreibung und Erklärung)

Zur Beschreibung und Erklärung der Ansteuerung der ersten elektrischen, - d.h. der induktiven - Einrichtung 190 wird wiederum auf Figur 1 Bezug genommen. Dabei sind die Sendeelektroden der zweiten elektrischen Einheit gedanklich durch Sendespulen zu ersetzen.

Insbesondere gilt für die erste elektrische Einrichtung: Dabei sind die erste Sendeelektrode 125 durch eine erste Sendespule 175, die zweite Sendeelektrode 130 durch eine zweite Sendespule 180 zu ersetzen. Die Empfangselektrode 135 wird durch eine einzelne Empfangsspule 185 oder durch ein System von Empfangsspulen, vorzugsweise zwei in Serie miteinander verbundene Empfangsspulen, ersetzt. Bevorzugterweise kann dabei wenigstens eine der Spulen als Leiterstruktur auf einer Platine ("Printspule") ausgeführt. In einer weiteren Ausführungsform kann die Empfangselektrode 135 durch einen einzelnen magnetoresistiven Magnetfeldsensor, vorzugsweise einen Hallsensor, oder durch ein System von magnetoresistiven Sensoren, vorzugsweise zwei in Serie miteinander verbundene magnetoresistive Sensoren, ersetzt. In einer weiteren Ausführungsform können anstelle der Empfangselektrode 135 auch magnetoresistive Magnetfeldgradientensensoren verwendet.

Im Folgenden erfolgt eine Erläuterung der Gegentakt-Messbrücke 100 unter Verwendung der Empfangsspule.185. Die Verwendung eines Systems von Empfangsspulen 185 oder von magnetoresistiven Magnetfeldsensoren oder Magnetfeldgradientensensoren erfolgt in analoger Weise.

Die Sendespulen 175, 180 erzeugen überlagerte Magnetfelder mit sich periodisch ändernden Amplituden und Phasen. Vorzugsweise erzeugen beide Sendespulen 175, 180 in jeder Halbwelle ihrer Versorgungsspannung Magnetfelder mit gleichen Amplituden und paralleler Orientierung der Hauptfeldrichtungen. Das Vorzeichen der Magnetfelder wechselt von Halbwelle zu Halbwelle. Hierzu werden die Sendespulen 175 und 180 gegensinnig gewickelt und ihre freien Enden jeweils mit Masse verbunden. Die Spannungsversorgung durch die steuerbaren Verstärker 115, 120 erfolgt mit bezüglich Masse entgegengesetzten Spannungen. Alternativ dazu erzeugen die Sendespulen 175 und 180 in einer Halbwelle Magnetfelder mit unterschiedlicher Amplitude und paralleler oder antiparalleler Orientierung der Hauptfeldrichtung. Die Amplitude und das Vorzeichen des von der Sendespule 175 in einer Halbwelle erzeugten Magnetfeldes entspricht der Amplitude bzw. dem Vorzeichen des von der Sendespule 180 in der vorangehenden bzw. darauffolgenden Halbwelle erzeugten Magnetfeldes. Hierzu sind die Wicklungssinne der Sendespulen 175, 180 sowie die Versorgungsspannungen der Sendespulen 175, 180 gegenüber Masse entsprechend anzupassen.

Die Empfangsspule 185 ist derart im Bereich der Sendespulen 175 und 180 angeordnet, dass sie dem überlagerten Magnetfeld beider Sendespulen 175 und 180 ausgesetzt ist. Bevorzugterweise ist die Anordnung der Spulen 175 bis 185 so gewählt, dass die in der Empfangsspule 185 durch die Magnetfelder der Sendespulen 175 und 180 induzierte Spannung Null, zumindest jedoch konstant ist, wenn die beiden steuerbaren Verstärker 115 und 120 gleiche Verstärkungsfaktoren aufweisen.

Bei Verwendung nur einer Empfangsspule 185 können z.B. die Sendespulen 175 und 180 koaxial in zwei parallelen Ebenen angeordnet sein und die Empfangsspule 185 wird in einer dritten parallelen Ebene angeordnet, die von den ersten beiden Ebenen jeweils den gleichen Abstand aufweist. Bei Verwendung eines Systems aus zwei miteinander verbundenen Empfangsspulen 185 können die Sendespulen 175 und 180 in zwei parallelen Ebenen angeordnet sein. Die beiden miteinander verbundenen Empfangsspulen 185 können jeweils in einer der beiden parallelen Ebenen angeordnet sein, vorzugsweise so, dass die Ausrichtung und Position je einer der Sendespulen 175, 180 zur Ausrichtung und Position je einer der Empfangsspulen 185 korrespondiert. Wicklungssinne und Verschaltungen der Empfangsspulen 185 werden aus der Bedingung bestimmt, dass die an dem System von Empfangsspulen 185 induzierte Spannung Null ist, wenn die beiden steuerbaren Verstärker 115 und 120 gleiche Verstärkungsfaktoren aufweisen. Erzeugen die beiden Sendespulen 175, 180 in jeder Halbwelle Magnetfelder mit gleicher Amplitude und paralleler Orientierung der Hauptfeldrichtung und wechselt das Vorzeichen der Magnetfelder von Halbwelle zu Halbwelle, so ist diese Bedingung z.B. erfüllt, wenn die beiden Empfangsspulen 185 in Serie geschaltet und gegensinnig gewickelt sind. Werden die beiden Empfangsspulen 185 in antiserieller Reihenschaltung betrieben, so müssen die Empfangsspulen 185 gleichsinnig gewickelt sein. Für die oben beschriebenen weiteren Fälle von alternativen, von den Sendespulen erzeugten und, überlagerten Magnetfelder ergeben sich sinngemäße Kombinationen aus Verschaltung der Empfangsspulen 185 und relativer Orientierung der Wicklungssinne der Empfangsspulen 185. Das vorbestimmte Verhältnis bezüglich der Sendespulen 175 und 180 ist in diesem Fall 1.

Bezüglich des Weglassens von Spulen 180, 185 und des Verwendens des Kompensationsnetzwerks 165 und der Impedanz 170 gelten in entsprechender Weise die obigen Erläuterungen bezüglich der Ausführungsform zur Bestimmung eines dielektrischen Gegenstandes .

Die Sendespulen 175 und 180 befinden sich an zumindest leicht axial oder lateral gegeneinander versetzten Positionen, so dass ein metallischer Gegenstand im Allgemeinen unterschiedliche Abstände zu den Sendespulen 175 und 180 einnimmt. Ein Aufenthalt des Gegenstandes in einer Ebene zwischen den Sendespulen 175 und 180, in der der Gegenstand im Fall axial versetzter Sendespulen 175, 180 gleichen Abstand zu den Sendespulen 175 und 180 aufweist, kann durch die Anordnung der Sendespulen 175 und 180 im Ortungsgerät 105 vermieden werden. Durch die asymmetrische Position des Gegenstandes bezüglich der Sendespulen 175 und 180 wird der Gegenstand durch die Magnetfelder der Sendespulen 175 und 180 unterschiedlich beeinflusst. Dementsprechend werden die Magnetfelder auch durch den metallischen Gegenstand unterschiedlich beeinflusst, so dass die von den überlagerten Magnetfeldern in der Empfangsspule 185 induzierte Spannung nicht mehr Null ist. Die Gegentakt-Messbrücke 100 kompensiert diese Asymmetrie, indem, wie oben ausgeführt ist, einer der Verstärker 115 und 120 zu einem höheren Verstärkungsfaktor als der andere der Verstärker 115, 120 angesteuert wird, bis die von den überlagerten Magnetfeldern in der Empfangsspule 185 induzierte Spannung wieder den Wert Null erreicht hat. Das variable Verhältnis zwischen den Sendespulen 175 und 180 entspricht dann nicht mehr 1 und am Anschluss 155 liegt eine Spannung an, die ungleich Null ist. Durch Vergleichen der am Anschluss 155 anliegenden Spannung mit dem vorbestimmten Wert Null (entsprechend dem vorbestimmten Verhältnis Eins) kann der metallische Gegenstand erfasst werden.

In Figur 6 ist noch einmal der schematische Aufbau des erfindungsgemäßen Ortungsgerätes in einer bevorzugten Ausführungsform dargestellt. Das Gerät weist zumindest eine Gegentakt-Messbrücke 100 ― wie beschrieben auf. Darüber hinaus sind eine erste elektrische Einrichtung 190 und eine zweite elektrische Einrichtung 195 vorgesehen, die über einen Umschalter 600 von der Gegentakt-Messbrücke 100 beaufschlagt werden können. So ist es möglich, mit (nur) einer GegentaktMessbrücke zwei elektrische Einrichtungen, d.h. zwei Sensoren zu betreiben.

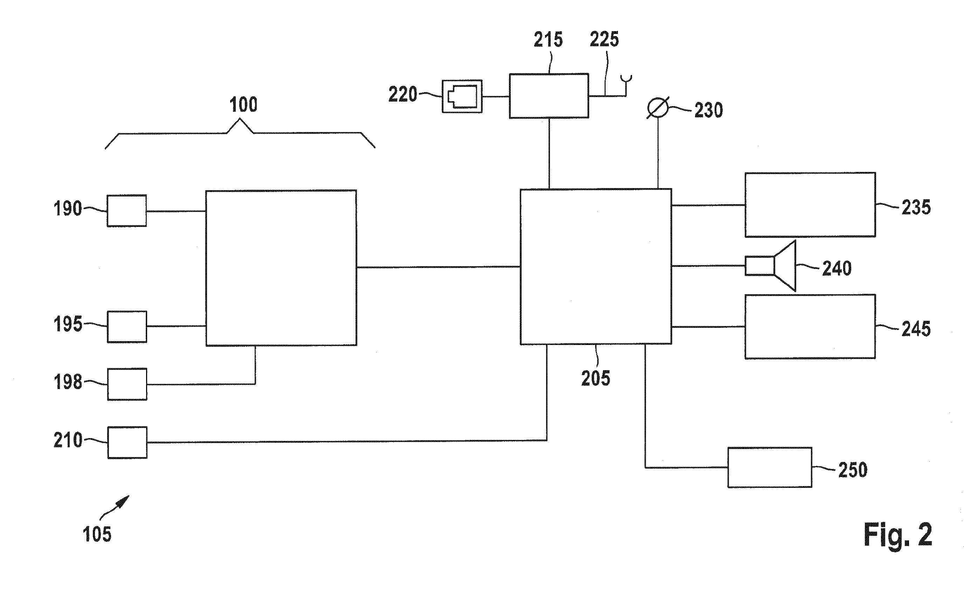

Fig. 2 zeigt eine schematische Darstellung des Ortungsgeräts 105 mit der Gegentakt-Messbrücke 100 aus Fig. 1. Die Gegentaktbrücke 100 ist dabei vorteilhafter Weise in einem IC, beispielsweise einem ASIC (Anwendungsspezifischer IC) integriert.

Das Ortungsgerät 105 umfasst eine Verarbeitungseinrichtung 205, die mit der Gegentakt-Messbrücke 100 verbunden ist. Ferner ist die Verarbeitungseinrichtung 205 mit einem Spannungssensor 210 und einer Energiesteuerung 215 verbunden, die ihrerseits mit einer Batterie 220, beispielsweise einem wiederaufladbaren Akku und einer Ladebuchse 225 verbunden ist. Darüber hinaus ist die Verarbeitungseinrichtung 205 mit einer Datenschnittstelle 230, einer optischen Ausgabeeinrichtung 235, einer akustischen Ausgabeeinrichtung 240, einer Eingabeeinrichtung 245 und einem Positionssensor 250 verbunden.

In der dargestellten Ausführungsform ist die Gegentakt-Messbrücke 100 getrennt von der Verarbeitungseinrichtung 205 aufgebaut. In einer anderen Ausführungsform können Elemente der Gegentakt-Messbrücke 100 auch durch die Verarbeitungseinrichtung 205 gebildet sein. Insbesondere kann der Umschalter zwischen erster elektrischer Einrichtung und zweiter elektrischer Einrichtung Teil der Verarbeitungseinrichtung 205 sein. Die Verarbeitungseinrichtung 205 ist vorzugsweise ein üblicher digitaler Mikrocomputer mit einem Arbeitstaktgenerator und Programm- und Datenspeichern. Zur Umwandlung zwischen digitalen Signalen der Verarbeitungseinrichtung 205 und analogen Signalen innerhalb der Gegentakt-Messbrücke 100 können einer oder mehrere Digital-Analog-Wandler (DAC) und wenigstens ein Analog-Digital-Wandler (ADC) vorgesehen sein. Insbesondere können durch die Verarbeitungseinrichtung 205 der Taktgenerator 110, die steuerbaren Verstärker 115 und 120, der Synchrondemodulator 145, der Integrator 150 und/oder der Inverter 160 implementiert sein.

Auch die Auswertung des am Anschluss 155 bereitgestellten Signals der GegentaktMessbrücke 105, welches auf das variable Verhältnis bezüglich der ersten und zweiten elektromagnetischen Einrichtung 190 und 195 hinweist, kann mittels der Verarbeitungseinrichtung 205 erfolgen. Dazu zählt der Vergleich des Signals mit einem vorbestimmten Wert und das Bestimmen, ob die Differenz zwischen dem Signal und dem vorbestimmten Wert ein vorbestimmtes Maß überschreitet. In einer anderen Ausführungsform können die beschriebenen Funktionalitäten auch durch diskrete Bauelemente implementiert sein, beispielsweise durch analoge Elektronikschaltungen oder in Form eines anwenderspezifischen ICs (ASIC).

Der Spannungssensor 210 ist ein bekannter Sensor, der ein elektromagnetisches Feld erfasst, das von einem stromdurchflossenen oder spannungsführenden Leiter generiert wird. In einer Ausführungsform werden ausschließlich elektromagnetische Wechselfelder eines vorbestimmten Frequenzbereichs durch den Spannungssensor 210 detektiert, beispielsweise im Frequenzbereich oberhalb von 20 Hz, bevorzugterweise in einem Bereich von ca. 45 bis 65 Hz. Weiter bevorzugterweise bestimmt der Spannungssensor 210 das elektromagnetische Feld durch die Aufgrund des elektrischen Feldes an einer Messelektrode des Spannungssensors 210 anliegende elektrische Spannung.

Zusätzlich zum Spannungssensor 210 können weitere, nicht dargestellte Hilfssensoren zur Verbesserung eines Messergebnisses der Gegentakt-Messbrücke 100 mit der Verarbeitungseinrichtung 210 verbunden sein. Dazu zählt beispielsweise ein Sensor, der bestimmt, ob die elektromagnetischen Einrichtungen 190 bis 198 in einer erforderlichen Weise bezüglich einer Messfläche ausgerichtet sind, insbesondere, ob Abstände zwischen der Messfläche und den elektromagnetischen Einrichtungen 190 bis 198 gleich groß sind. Ein Verkippen des Ortungsgeräts 105 bezüglich der Messfläche kann dadurch verhindert werden. Die Messfläche ist üblicherweise die Oberfläche eines Körpers, in welchem der zu erfassende Gegenstand aufgenommen ist. Der Körper kann eine Mauer oder Wand und der Gegenstand in dieser verborgen sein.

Die Energiesteuerung 215 versorgt das Ortungsgerät 105 mit zum Betrieb erforderlichen Spannungen. Üblicherweise wird die hierfür erforderliche elektrische Energie aus der Batterie 220, beispielsweise einem wiederaufladbaren Akku entnommen. Zum Aufladen der Batterie 220 kann der Energiesteuerung 215 über die Ladebuchse 225 elektrische Energie zugeführt werden, wobei die Energiesteuerung 215 das Laden der Batterie 220 steuert und überwacht. Ein Betrieb des Ortungsgeräts 105 auf der Basis von elektrischer Energie, die ausschließlich über die Ladebuchse 225 zugeführt ist, ist ebenfalls möglich. Die Ladebuchse 225 ist üblicherweise ein Niedervolt-Stecker, dessen Gegenstück mit einem Netzgerät verbunden ist. In einer Ausführungsform kann eine Ladestation vorgesehen sein, in die das Ortungsgerät 105 eingelegt wird, wobei die Ladebuchse 225 elektrisch mit dem Netzgerät verbunden wird, so dass die Batterie 220 aufgeladen werden kann. In einer weiteren Ausführungsform kann das Netzteil auch im Ortungsgerät 105 aufgenommen sein und die Ladebuchse 225 kann mit dem üblichen Stromnetz verbunden werden.

Teile der Logik zur Versorgung des Ortungsgeräts 105 mit elektrischer Energie und zur Steuerung des Ladevorgangs der Batterie 220 können durch die Verarbeitungseinrichtung 205 implementiert sein. Ferner kann die Verarbeitungseinrichtung 205 auf die Energiesteuerung 215 einwirken, beispielsweise in Form einer automatischen Abschaltung des Ortungsgeräts 105 nach einer vorbestimmten Zeit, in der das Ortungsgerät 105 nicht benutzt wurde, oder in Form einer Abfrage eines gegenwärtigen Ladezustands der Batterie 220.

Mittels der Datenschnittstelle 230 kann die Verarbeitungseinrichtung 205 Informationen mit einem externen Gerät austauschen. Derartige Informationen können Messergebnisse betreffen, die erhoben wurden oder in einem Speicher der Verarbeitungseinrichtung 205 vorgehalten sind. Die Datenschnittstelle 230 und die Ladebuchse 225 können miteinander integriert ausgeführt sein. Vorzugsweise ist die Datenschnittstelle 230 eine digitale serielle Datenschnittstelle, insbesondere eine USB-Schnittstelle.

Die optische Ausgabeeinrichtung 235 umfasst in einer ersten Ausführungsform eine Anzahl Leuchtdioden zur Visualisierung eines Messergebnisses der GegentaktMessbrücke 100. Weitere Leuchtdioden zur Darstellung interner Zustände des Ortungsgeräts 105 können ebenfalls umfasst sein, beispielsweise zur Anzeige eines Ladezustands der Batterie.

In einer zweiten Ausführungsform, die jedoch mit der ersten Ausführungsform kombinierbar ist, umfasst die optische Anzeigeeinrichtung 235 eine grafische Anzeige, etwa eine Flüssigkristall-Anzeige (LCD). Das LCD kann eine Hintergrundbeleuchtung, beispielsweise mittels LED oder OLED umfassen und einen Bereich mit einer Punktmatrix umfassen, auf dem einzelne Punkte selektiv angezeigt werden können. Sowohl das LCD als auch die Hintergrundbeleuchtung oder die Leuchtdioden des ersten Ausführungsbeispiels können mehrere Ausgabefarben unterstützen. In einer bevorzugten Ausführungsform ist die optische Ausgabeeinrichtung derart ausgeführt, dass ein Betrieb des Ortungsgeräts 105 sowohl in einer hellen als auch in einer dunklen Umgebung möglich ist. Dazu kann eine Leuchthelligkeit der LED bzw. der Hintergrundbeleuchtung des LCD an die Lichtverhältnisse in der Umgebung angepasst werden.

Die akustische Ausgabeeinrichtung 240 kann einen Lautsprecher oder einen Piezowandler umfassen. Die Darstellung eines Messergebnisses der GegentaktMessbrücke 100 kann mittels der optischen Ausgabeeinrichtung 235 und der akustischen Ausgabeeinrichtung 240 optisch, akustisch oder kombiniert optisch und akustisch ausgegeben werden. Beispielsweise kann eine Position eines erfassten Gegenstands auf der optischen Ausgabeeinrichtung 235 angezeigt werden, während ein charakteristisches Geräusch aus der akustischen Ausgabeeinrichtung 240 auf eine metallische Eigenschaft des Gegenstandes hinweist. Eine Farbe des optisch dargestellten Gegenstandes kann auf eine Entfernung, insbesondere eine Tiefe des Gegenstandes versinnbildlichen. Zuordnungen zwischen der Farbe und des Geräuschs zu Eigenschaften des Gegenstandes (metallisch, dielektrisch, spannungsführend) können veränderbar sein, in einer Ausführungsform auch durch einen Benutzer des Ortungsgeräts 105.

Mittels der Eingabeeinrichtung 245 kann der Benutzer das Ortungsgerät 105 bedienen. Die Eingabeeinrichtung 245 kann eine Anzahl von Tasten umfassen, die in einer Tastatur zusammengefasst sein können. In einer Ausführungsform umfasst die Eingabeeinrichtung 245 lediglich eine einzige Taste, wobei eine vollständige Bedienbarkeit des Ortungsgeräts 105 mittels dieser einen Taste gewährleistet ist. Die Eingabeeinrichtung 245 kann teilweise oder vollständig hintergrundbeleuchtet sein. Die Hintergrundbeleuchtung kann mit einer Hintergrundbeleuchtung der optischen Ausgabeeinrichtung 235 gekoppelt sein. Alternativ oder zusätzlich kann die Hintergrundbeleuchtung benutzergesteuert sein. Ferner kann die Eingabeeinrichtung 245 weitere Eingabemittel umfassen, insbesondere einen Dreh- oder Schieberegler. Ein solcher Regler kann analog oder digital abgetastet sein und insbesondere zur stufenlosen oder feingranularen Änderung eines Parameters des Ortungsgeräts 105 dienen. Mittels eines solchen Reglers kann eine Empfindlichkeit der GegentaktMessbrücke 100 einstellbar sein. Außerdem kann die Eingabeeinrichtung 245 ganz oder in Teilen mit der optischen Ausgabeeinrichtung 235 in Form eines berührempfindlichen Bildschirms ("touchscreen") integriert ausgeführt sein.

Der Positionssensor 250 dient der Bestimmung einer Position des Ortungsgeräts 105 bezüglich der Messfläche durch Erfassen einer Verschiebung des Ortungsgeräts 105 bezüglich der Messfläche. Die Erfassung kann eindimensional oder zweidimensional erfolgen. Dazu kann beispielsweise ein Beschleunigungssensor, vorzugsweise ein mikromechanischer Beschleunigungssensor, verwendet werden. Alternativ dazu kann ein Laufrad im Bereich zwischen dem Ortungsgerät 105 und der Messfläche angeordnet sein, wobei eine Drehung des Laufrades durch die Verarbeitungseinrichtung 205 in eine Verschiebung umgerechnet wird. Im zweidimensionalen Fall kann eine Mechanik ähnlich derer in einer Computermaus verwendet werden, indem eine Rollkugel zwischen dem Ortungsgerät 105 und der Messfläche gehalten ist, und eine Verschiebung des Ortungsgeräts 105 auf der Basis einer Bewegung der Rollkugel in zwei Dimensionen abgetastet wird. In noch einer weiteren Ausführungsform kann eine optische Abtastung ähnlich einer optischen Computermaus durchgeführt werden, wobei der Positionssensor 250 eine Kamera umfasst, die auf die Messfläche gerichtet ist, und der Positionssensor 250 eine Verschiebung des von der Kamera aufgenommenen Bildes in eine Verschiebung des Ortungsgeräts 105 bezüglich der Messfläche umrechnet. Die Umrechnung kann auch durch die Verarbeitungseinrichtung 205 durchgeführt werden. Im Bereich der Kamera kann eine Lichtquelle, beispielsweise in Form einer oder mehrerer Leuchtdioden, angeordnet sein.

Neben der einen dargestellten Gegentakt-Messbrücke 100 können auch weitere Gegentakt-Messbrücken 100 vom Ortungsgerät 105 umfasst und mit der Verarbeitungseinrichtung 205 verbunden sein.

Ferner können unterschiedliche elektromagnetische Einrichtungen 190 bis 198, gesteuert durch die Verarbeitungseinrichtung 205, mit der einen oder den mehreren Gegentakt-Messbrücken 100 verbindbar sein, so dass mittels unterschiedlich ausgebildeter bzw. an unterschiedlichen Positionen befindlicher elektromagnetischer Einrichtungen 190 bis 198 Messungen durchgeführt werden können.

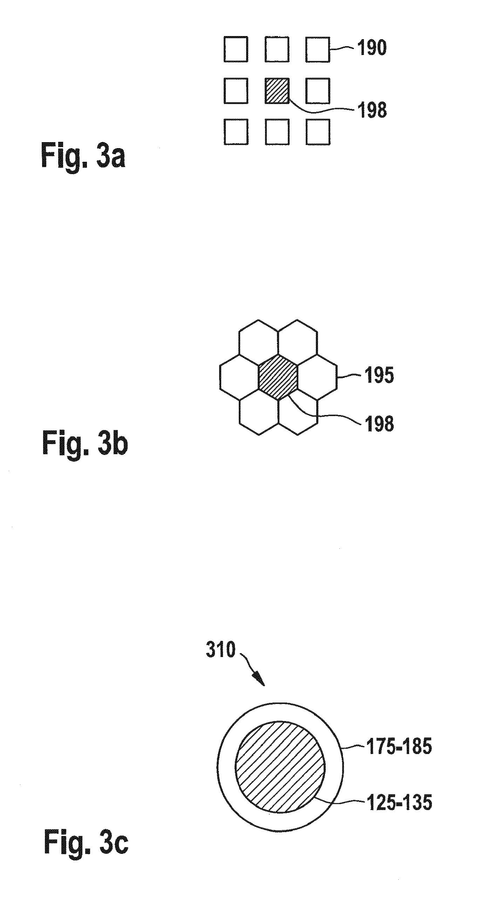

Fig. 3 zeigt unterschiedliche Anordnungen der elektromagnetischen Einrichtungen 190 bis 198 für eine Gegentakt-Messbrücke 100 aus Fig. 1. Fig. 3A zeigt eine matrixartige Anordnung. Das dritte elektromagnetische Element 198 bildet das mittlere Element einer 3x3-Matrix, deren restliche Elemente durch erste und zweite elektromagnetische Einrichtungen 190, 195 gebildet sind. Bezüglich des dritten elektromagnetischen Elements 198 liegen einander jeweils ein erstes elektromagnetisches Element 190 und ein zweites elektromagnetisches Element 195 gegenüber.

In zeitlicher Abfolge werden unterschiedliche Paare einander gegenüberliegender erster bzw. zweiter elektromagnetischer Einrichtungen 190, 195 mittels des Umschaslters mit der Gegentakt-Messbrücke 100 verbunden, so dass entlang einer Verbindungslinie der gegenüberliegenden Einrichtungen 190, 195 bestimmt werden kann, auf welcher Seite der dritten elektromagnetischen Einrichtung 198 der Gegenstand angeordnet ist. Dadurch kann die Position des Gegenstandes bezüglich der dritten elektromagnetischen Einrichtung in mehreren Richtungen der Ebene der elektromagnetischen Einrichtungen 190 bis 198 bestimmt werden.

Fig. 3B zeigt eine wabenförmige Anordnung von elektromagnetischen Einrichtungen 190 bis 198. Hier weist die dritte elektromagnetische Einrichtung 198 sechs statt acht benachbarte elektromagnetische Einrichtungen 190, 195 auf. Insbesondere dann, wenn die elektromagnetischen Einrichtungen 190, 195 Spulen umfassen, kann die in Fig. 3B gezeigte Ausführungsform von Vorteil sein, da sich die Spulen besser an die Wabenform als an die Rechteckform in Fig. 3A annähern lassen. So kann eine Flächenpackungsdichte der elektromagnetischen Einrichtungen 190 bis 198 in wabenförmiger Anordnung erhöht sein.

Die in den Figuren 3A und 3B dargestellten Anordnungen können in beliebigen Richtungen in der Zeichenebene fortgesetzt sein. Dadurch kann prinzipiell eine beliebig große Anordnung von elektromagnetischen Einrichtungen 190 bis 198 unterstützt werden. Sind mehrere Gegentakt-Messbrücken 100 im Ortungsgerät 105 vorgesehen, so können auch mehrere Messungen gleichzeitig vorgenommen werden, wobei auf ausreichenden Abstand aktiver elektromagnetischer Einrichtungen 190 bis 198 zu achten ist, um gegenseitige Beeinflussungen zu vermeiden. Die an einer Messung beteiligten elektromagnetischen Einrichtungen 190 bis 198 müssen nicht aneinander angrenzen, sondern können durch weitere, vorzugsweise nicht verschaltete elektromagnetische Einrichtungen 190 bis 198 voneinander getrennt sein.

Im Zwei-Elektroden-Messbetrieb der ersten elektrischen Einrichtung (vgl. oben mit Bezug auf Fig. 1) können die in Fign. 3A und 3B gezeigten Anordnungen in entsprechender Weise verschaltet werden.

Fig. 3C zeigt eine beispielhafte Ausführungsform eines kombinierten Messelements 310 für die erste und die zweite elektrische Einheit. Das kombinierte Messelement 310, umfasst eine kreisscheibenförmige Elektrode 125 bis 135, die von einer runden Spule 175 bis 185 umschlossen ist. Zentren der Elektrode 125 bis 135 und der Spule 175 bis 185 fallen zusammen, um Gegenstände mit unterschiedlichen Eigenschaften (metallisch, dielektrisch) bezüglich der gleichen Position erfassen zu können.

Das Messelement 310 kann in den in den Figuren 3A und 3B gezeigten Anordnungen verwendet werden. Der Spannungssensor 210 kann mit einer der elektromagnetischen Einrichtungen 190 bis 198 integriert ausgeführt sein. Der Spannungssensor kann auch auf einer der Messfläche abgewandten Seite der elektromagnetischen Einrichtungen 190 bis 198 angeordnet sein.

Fig. 4 zeigt eine Visualisierung einer grafischen Anzeige des Ortungsgeräts 105 aus Fig. 2. Eine grafische Ausgabe 410 ist in eine Anzahl Anzeigebereiche 420, 430 matrixartig unterteilt. Die Anzeigebereiche 420 sind hell, die Anzeigebereiche 430 dunkel eingefärbt. Die dunkel eingefärbten Anzeigebereiche 430 repräsentieren Positionen, an denen der Gegenstand erfasst wurde. Anstelle einer Unterteilung in dunkel und hell kann auch eine Graustufen- bzw. Falschfarbendarstellung verwendet werden, wobei die dargestellte Graustufe bzw. Farbe eine Entfernung des Gegenstandes oder eine Eigenschaft des Gegenstandes (metallisch, dielektrisch, spannungsführend) signalisiert. Jeder der Anzeigebereiche 420, 430 korrespondiert zu einer dritten elektromagnetischen Einrichtung 198 in einer matrixartigen Anordnung wie in Fig. 3A.

Die Ausgabe 410 gibt einen optischen Eindruck über eine Größe und Lage des zu erfassenden Gegenstandes. In Fig. 4 befinden sich symbolhaft weitere Anzeigebereiche 420, 430 außerhalb der Ausgabe 410. Diese repräsentieren Messergebnisse, die mittels des Ortungsgeräts 105 an anderen Positionen durchgeführt und abgespeichert wurden. Durch Verschieben des Messgeräts 105 auf der Messfläche kann der auf der Ausgabe 410 dargestellte Ausschnitt über diese gespeicherten Messwerte verschoben werden. Dabei können unterschiedliche graphische Verarbeitungen der abgespeicherten Messwerte durchgeführt werden. Beispielsweise können die Messwerte jeweils das variable Verhältnis repräsentieren und ein Vergleich mit dem vorbestimmten Verhältnis und eine entsprechende Darstellung auf der Ausgabe 410 in hell oder dunkel kann jeweils "frisch" für die Anzeigebereiche 420, 430 im Bereich der Ausgabe 410 durchgeführt werden. Dabei kann das vorbestimmte Verhältnis entsprechend einer Benutzereingabe angepasst sein. Dadurch ist es für einen Benutzer leicht möglich, eine Kontur des Gegenstandes auf der Ausgabe 410 sichtbar zu machen, indem er das Ortungsgerät 105 gegenüber der Messfläche verschiebt und den entsprechenden Darstellungsparameter für die Ausgabe 410 justiert. Die Anpassung des Parameters kann insbesondere mittels eines Schiebe- oder Drehreglers erfolgen.

In einer weiteren Ausführungsform kann anstelle der Graustufen bzw. Farben der Anzeigebereiche 420, 430 eine Balkendarstellung treten, wobei die Länge eines Balkens einem Wert des variablen Verhältnisses oder dessen Abweichung von dem vorbestimmten Verhältnis entsprechen kann. Diese Darstellungsart eignet sich insbesondere für eine nur eindimensionale Verschiebbarkeit des Ortungsgeräts 105 gegenüber der Messfläche. Über die Ausgabe 410 hinausgehende, gespeicherte Anzeigebereiche 420, 430 bestehen dann nur in einer Flächenrichtung, also entweder horizontal oder vertikal. Ist das Ortungsgerät 105 vertikal verschiebbar, so sind die Balken vorzugsweise horizontal dargestellt und umgekehrt.

In weiteren Ausführungsformen können abgespeicherte Anzeigebereiche innerhalb der Anzeige beispielsweise lupenartig vergrößert werden, so dass eine Gruppe aneinander angrenzender Anzeigebereiche 420, 430 nur einen Messwert visualisieren. Fig. 5 zeigt eine Ansicht eines beispielhaften Ortungsgerätes 105. Das Ortungsgerätes 105 umfasst eine Eingabeeinrichtung und eine optische Ausgabeeinrichtung in Form eines Displays.

Das Ortungsgeräts 105 ist in einem Gehäuse 510 aufgenommen. In einem unteren Bereich des Gehäuses ist ein Handgriff angeordnet, der jedoch auch auf der Oberseite des Gerätes ausgebildet sein kann. Das Ortungsgerät 105 kann nach 1P54 Standard abgedichtet sein.

Die Darstellung der Messergebnisse, d.h. die Signalisierung der Detektion von gefundenen Objekte kann beispielsweise über ein Segment- oder Dot-Matrix-Display visualisiert werden.

In einer weiteren Ausführungsform, die jedoch mit der anderen Ausführungsform enkombinierbar ist, umfasst die optische Anzeigeeinrichtung 235 eine grafische Anzeige, etwa eine Flüssigkristall-Anzeige (LCD). Das LCD kann eine Hintergrundbeleuchtung, beispielsweise mittels LED oder OLED umfassen und einen Bereich mit einer Punktmatrix umfassen, auf dem einzelne Punkte selektiv angezeigt werden können. Sowohl das LCD als auch die Hintergrundbeleuchtung oder die Leuchtdioden des ersten Ausführungsbeispiels können mehrere Ausgabefarben unterstützen. In einer bevorzugten Ausführungsform ist die optische Ausgabeeinrichtung derart ausgeführt, dass ein Betrieb des Ortungsgeräts 105 sowohl in einer hellen als auch in einer dunklen Umgebung möglich ist. Dazu kann eine Leuchthelligkeit der LED bzw. der Hintergrundbeleuchtung des LCD an die Lichtverhältnisse in der Umgebung angepasst werden.

Hierbei kann es sich auch um ein Display mit Touch-Funktion handeln.

Folgende Funktionen können vorteilhafter Weise einzeln oder in Kombinationen bei der Ausgabeeinheit des erfindungsgemäßen Gerätes abgedeckt sein:
- Die Art des Objektes (ferromagnetisch / nicht ferromagnetisch / nicht metallisch). kann durch ein Symbol dargestellt werden
- Eine Zoom-Anzeige, beispielsweise auch optional vom Benutzer wählbar, kann vorgesehen sein, zur Steigerung die visualisierte Sensitivität.
- Dabei ist insbesondere eine Zoom-Anzeige mit Mittenfindung, z.B. mit Bargraph
   von Vorteil
- Eine Tiefenanzeige des gefundenen Objekts ist vorteilhaft
- Eine Signalstärkenanzeige, beispielsweise mit einem Bargraph kann mit Display des erfindungsgemäßen Gerätes realisiert sein
- Eine Hintergrundbeleuchtung für die Ausgabeeinheit kann die Ablesbarkeit bei schlechten Lichtverhältnissen verbessern. Dabei kann die Hintergrundbeleuchtung des erfindungsgemäßen Ortungsgerätes beispielsweise mit LEDs/ OLEDs aufgebaut sein.

Das handgehaltene Ortungsgerät verfügt des Weiteren über eine Eingabeeinheit in Form einer Taste bzw. Tastatur. Dabei können u.a. folgende Varianten abgedeckt sein:
- Ein-Knopf-Bedienung (Gleichzeitiges Messen mit verschiedenen Sensoren)
- manuelle Modusvorwahl zur Optimierung der Sensorleistung
- Ein /Aus Schalter
- Hintergrundbeleuchtete Tastatur
- Sensitivitäts-Wahl

Im Ausführungsbeispiel der Figur 5 steuert beispielsweise ein Taster 245 alle Funktionen des Ortungsgeräts 105. Im einfachsten Fall wird mittels des Tasters 245 lediglich ein Ein- und Ausschalten des Ortungsgeräts 105 gesteuert. Durch längere oder kürzere, einfache und mehrfache Tastendrücke auf den Taster 245 können auch weitere Funktionen des Ortungsgeräts 105 gesteuert werden, beispielsweise eine Umschaltung einer Empfindlichkeit, eine Kalibrierung oder eine Ausgabe des Ladezustandes der Batterie 220.

Alternative Ausführungsformen sehen ein Tastenfeld mit mehreren Bedientasten, beispielsweise auch Auswahltasten, ob mit der ersten oder der zweiten Elektrischen Einheit gemessen werden soll.

Das erfindungsgemäße Gerät verfügt zudem über eine geräteinterne Energieversorgung, die durch Batterien oder aber auch wiederaufladbare Akkus gebildet sein kann.

Die Akkus können fest im Gerät integriert sein oder aber auch zu Ladezwecken dem Gerät entnommen werden.

Vorteilhafter Weise ist die Ladeelektronik im Gerät integriert. Die Zufuhr von externer Energie erfolgt dann über eine Schnittstelle an Gehäuse des Gerätes, wie beispielsweise einem Niedervoltstecker oder auch einer USB-Buchse

In vorteilhafter Weise kann eine USB-Buchse als kombinierte Datenschnittstelle 230 und Ladebuchse 225 vorhanden sein, wie dies in Figur 6 dargestellt ist.

Alternativer Weise oder zusätzlich kann die Ausgabeeinheit aber auch die Darstellung von Messerergebnissen über LEDs ermöglichen. Die Schwellen der einzelnen LEDs können dabei über einen im Gerät integrierten Controller oder über eine analoge Elektronik generiert werden. Dabei kann z.B. über farbige LEDs die Mittenfindung visualisiert werden, oder auch eine AC-Leitung angezeigt werden.

Die Leuchtdioden 235 im Ausführungsbeispiel der Figur 5 zeigen eine Position des Gegenstandes links bzw. rechts einer Mittenmarkierung 520 auf dem Gehäuse 510 an. Nicht sichtbare elektromagnetische Einrichtungen 190 bis 198 sind bezüglich der Mittenmarkierung 520 zentriert angeordnet. Leuchten beide Leuchtdioden 235 gleich hell, so befindet sich der Gegenstand gleichmäßig unter der Mittenmarkierung 520. Um eine Kante des Gegenstandes zu finden, muss das Ortungsgerät 105 so lange verschoben werden, bis die Leuchtdioden 235 unterschiedlich hell leuchten. Idealerweise befindet sich die Kante des Gegenstandes unmittelbar unterhalb der Mittenmarkierung 520, wenn die eine Leuchtdiode 235 ausgeschaltet ist und die andere Leuchtdiode 235 maximale Helligkeit erreicht hat.

Alternativ oder zusätzlich zu den Leuchtdioden 235 kann die optische Anzeigeeinrichtung 235 eine grafische Anzeige, etwa eine Flüssigkristall-Anzeige (LCD). Das LCD kann eine Hintergrundbeleuchtung, beispielsweise mittels LED oder OLED umfassen und einen Bereich mit einer Punktmatrix umfassen, auf dem einzelne Punkte selektiv angezeigt werden können. Sowohl das LCD als auch die Hintergrundbeleuchtung oder die Leuchtdioden des ersten Ausführungsbeispiels können mehrere Ausgabefarben unterstützen. In einer bevorzugten Ausführungsform ist die optische Ausgabeeinrichtung derart ausgeführt, dass ein Betrieb des Ortungsgeräts 105 sowohl in einer hellen als auch in einer dunklen Umgebung möglich ist. Dazu kann eine Leuchthelligkeit der LED bzw. der Hintergrundbeleuchtung des LCD an die Lichtverhältnisse in der Umgebung angepasst werden.

Alternativ oder zusätzlich zu der optischen Ausgabeeinheit kann das erfindungsgemäße Ortungsgerät auch über einen Akustikgeber verfügen. Hierbei kann es sich beispielsweise um einen Lautsprecher bzw. eine Piezowandler handeln, mit dem beispielsweise die Detektion einer AC Leitung signalisiert werden kann. Auch kann der Akustikgeber über einen Controller (oder eine analoge Schwellen-generierende Elektronik) abhängig von der Signalstärke des Messsystems mit unterschiedlichen Frequenzen/Rhythmen betrieben werden, um somit eine Objekt-Detektion und Differenzierung zu signalisieren.

Des Weiteren kann das erfindungsgemäße Ortungsgerät einen mechanischen oder optischen Weggeber besitzen. Mechanische Weggeber (Räder mit Lichtschranke und Segmentscheibe) oder optische Weggeber (wie beispielsweise optische Maussensoren) oder Beschleunigungssensoren erfassen dabei die Wegstrecke die das handgehaltene Ortungsgerät über einer Oberfläche verfahren wird. Diese Information wird der Signalverarbeitung zur Verfügung gestellt, um z.B. die Sensorleistung oder die Anzeige zu verbessern. Insbesondere können somit auch die Detektionsdaten konkreten Ortspositionen des Gerätes zugeordnet werden.

Die im Gehäuse des Gerätes angeordnet Elektronik besitzt in vorteilhafter Weise zumindest einen Controller, mit dem das hier beschriebenen Messverfahren und die Funktionen des Gerätes, wie teilweise schon ausgeführt, gesteuert werden können. Der Controller kann dabei eine Vielzahl von Funktionen, wie beispielsweise eine NMI Schnittstelle, eine Ladeelektronik Steuerung oder Regelung oder auch eine "Auto-Aus Funktion" kontrollieren bzw. abdecken. Alternativ kann die Funktion des Controllers, insbesondere für die Gehäusefunktionen, auch durch eine analoge Elektronik abgedeckt werden.

## Patentansprüche

1. Ortungsgerät (105), insbesondere Handortungsgerät, zur Detektion von in einem Medium eingeschlossenen Objekten, zumindest aufweisend:
- ein Gehäuse,
- ein im oder am Gehäuse vorgesehene Ausgabeeinrichtung in Form eines Displays
- eine im Gehäuse angeordnete, erste elektrische Einrichtung (190) in Form zumindest zweier elektromagnetische Spulen
- wobei die erste elektrische Einrichtung (190) derart ausgebildet ist, dass sie in Abhängigkeit der Ansteuerung ein elektromagnetisches Wechselfeld im Bereich eines Objektes erzeugt;
- eine im Gehäuse angeordnete zweite elektrische Einrichtung (195) in Form zumindest zweier Elektroden
- wobei die zweite elektrische Einrichtung (195) derart ausgebildet ist, dass sie in Abhängigkeit der Ansteuerung ein elektrische Feld im Bereich des Objektes erzeugt;
- eine im Gehäuse angeordnete Ansteuervorrichtung (100) in Form einer Gegentakt-Messbrücke (100) zur Ansteuerung der ersten (190) und/oder der zweiten (195) elektrischen Einrichtung, jeweils mit alternierenden Spannungen mit variierbarem
Verhältnis
- **dadurch gekennzeichnet, dass**
- ein Vergleicher (205) vorgesehen ist, der dazu eingerichtet ist, ein Signal zu generieren, das ein Objekt als erfasst kennzeichnet, falls sich das jeweilige Verhältnis der Spannungen der ersten und/oder der zweiten elektrischen Einrichtung von einem vorbestimmten Verhältnis um mehr als ein vorgebbares Maß unterscheidet.
- die Ausgabeeinrichtung zur Ausgabe eines auf das Objekt hinweisenden Signals, vorgesehen ist, falls sich das jeweilige Verhältnis der Spannungen der ersten und/oder der zweiten elektrischen Einrichtung von einem vorbestimmten Verhältnis um mehr als ein vorgebbares Maß unterscheidet

2. Ortungsgerät (105) nach Anspruch 1, **dadurch gekennzeichnet, dass** die alternierenden Spannungen zueinander phasenverschobene Wechselspannungen sind.

3. Ortungsgerät (105) nach Anspruch 2, **dadurch gekennzeichnet, dass** die alternierenden Spannungen um 180° phasenverschobene Wechselspannungen sind.

4. Ortungsgerät (105) nach Anspruch 1, 2 oder 3, **dadurch gekennzeichnet, dass** die Ansteuervorrichtung dazu eingerichtet ist, die alternierenden Spannungen zueinander gegenläufig zu verstärken.

5. Ortungsgerät (105) nach Anspruch 1, **dadurch gekennzeichnet, dass** eine Einrichtung (245) zur Veränderung des Größe des vorbestimmten Maßes vorgesehen ist.

6. Ortungsgerät (105) nach Anspruch 1, **dadurch gekennzeichnet, dass** dieses einen Umschalter (600) aufweist, der es ermöglicht, ein Signal der Gegentaktmessbrücke alternativ auf die erste (190) oder die zweite (195) elektrische Einrichtung zu schalten.

7. Ortungsgerät (105) nach einem der vorangehenden Ansprüche, **dadurch gekennzeichnet, dass** die als Gegentakt-Messbrücke (100) ausgebildete Ansteuervorrichtung in Form eines IC, insbesondere in Form eines ASIC, ausgebildet und im Gehäuse der Vorrichtung angeordnet ist.

8. Ortungsgerät (105) nach einem der vorangehenden Ansprüche, **dadurch gekennzeichnet, dass** das von der Ausgabeeinrichtung auf das Objekt hinweisende Signal darauf hinweist, welcher Art von Gegenstand erfasst wurde.

9. Ortungsgerät (105) nach einem der vorangehenden Ansprüche, **dadurch gekennzeichnet, dass** eine Entfernung des Gegenstandes vom Ortungsgerät (105) zu einer Farbänderung der Ausgabeeinrichtung (235) korrespondiert.

10. Ortungsgerät (105) nach einem der vorangehenden Ansprüche, **gekennzeichnet durch** einen Abstandssensor zur Sicherstellung eines flächigen Aufliegens des Ortungsgerät (105) auf einer Messfläche.

11. Ortungsgerät (105) nach einem der vorangehenden Ansprüche, **gekennzeichnet durch** einen Weggeber zur Erfassung einer Verschiebung des Ortungsgeräts gegenüber dem Gegenstand, wobei das Ortungsgerät (105) dazu ausgebildet ist, ein Messergebnis der Gegentakt-Messbrücke (100) einer Verschiebungsposition zuzuordnen.

12. Ortungsgerät (105) nach einem der vorangehenden Ansprüche, zumindest umfassend:
eine weitere Gegentakt-Messbrücke (100) mit einer weiteren elektromagnetischen Einrichtung (190).

13. Ortungsgerät (105) nach einem der vorangehenden Ansprüche, **dadurch gekennzeichnet, dass** zumindest eine der elektromagnetische Einrichtungen (190, 195) an einer Seite des Gehäuses (510), insbesondere an der der Ausgabeeinrichtung abgewandten Seite des Gehäuses, innerhalb des Gehäuses angeordnet sind.

14. Ortungsgerät (105) nach einem der vorangehenden Ansprüche, **dadurch gekennzeichnet, dass** es zumindest eine Batterie (220), insbesondere zumindest eine Batterie in Form eines einen wiederaufladbaren Akkus, zur Energieversorgung umfasst.
